# EUROPEAN PATENT APPLICATION

(11) **EP 1 998 087 A1**
(43) Date of publication of application: **03.12.2008**
(21) Application number: 07740201.4
(22) Date of filing: 22.03.2007
(51) Int. Cl.: F16J 15/10, C08G 18/77, C09K 3/10

(54) **WATERPROOF GASKET**

(30) Priority: 22.03.2006 JP 2006078099
(71) Applicant: NOK Corporation, Minato-ku Tokyo 105-8585 (JP)
(72) Inventor: KANAGAE, Hidekazu, Aso-shi, Kumamoto 869-2231 (JP); SHOJIMA, Daihachi, Aso-shi, Kumamoto 869-2231 (JP)
(74) Representative: TBK-Patent
(86) International application number: PCT/JP2007/056763
(87) International publication number: WO 2007/108560

(57) **Abstract**

A waterproof gasket that ensures easy handling and maintains desirable sealing capability between two members of a resin material made housing of mobile phone in contact with the waterproof gasket. There is provided a waterproof gasket to be fitted between members as constituents of electronic appliance housing, comprising a gasket main bodymade of a rubbery elastomer material and a surface layer resulting from treatment of the surface of the gasket main body with a reactive surface treating agent.

## Description

### BACKGROUND OF THE INVENTION

### Field of the Invention

The present invention relates to a waterproof gasket. Further, the present invention relates to a waterproof gasket effectively used for sealing a part between two members. Further, the present invention relates to a waterproof gasket to prevent leaking from a part between fixed members. Furthermore, the present invention is effectively used as a waterproof gasket for an electronic apparatus such as a cellular phone or a camera. More particularly, the present invention relates to a waterproof gasket to seal a clearance between resin cases. Preferably, the present invention is effectively used for a clearance between two members of a case made of a resin material of a cellular phone.

### Description of the Conventional Art

Conventionally, a waterproof gasket is provided at a contacting portion of a case of an electronic apparatus, e.g., a case of a cellular phone, in order to waterproof it. Such a waterproof gasket made of a rubber material is generally a low hardness silicone rubber having excellent adhesivity and follow-up ability with respect to a case.

Further, a waterproof gasket is attached to a case by forming a line groove at a contacting portion of a case and fitting a waterproof gasket into the line groove.

However, a waterproof gasket made of a low hardness silicone rubber is easily extended and twisted, and thus hardly handled. Therefore, there is a problem that an attaching operation to fit a waterproof gasket into a line groove of a case is remarkably hard.

A technique to embed a metal wire or a hard resin material in a waterproof gasket, and a technique to enclose a high hardness rubber with a low hardness rubber are proposed (Japanese Patent Application Publication Laid-Open No. H10-169780).

However, these techniques are hardly applied to a remarkably thin waterproof gasket having a fine wire shape of 0.4 mm to 1.6 mm.

Further, as for the technique to enclose a high hardness rubber with a low hardness rubber, since a low hardness rubber is exposed on the surface, there are problems that waterproof gaskets adhere to each other at the exposed portions and dusts adhere to the exposed portion.

Further, a method to coat the surface of a waterproof gasket by using a dispersion solution of a tetrafluoroethylene resin is proposed.

This method is effective to solve the problems that waterproof gaskets are adhered to each other and dusts are adhered. However, since a particle size of a tetrafluoroethylene resin is tens of µm, the surface of the gasket is rough. Thus, sufficient sealing ability cannot be expected. Further, there is a problem that a coating layer of a tetrafluoroethylene resin peels off.
[Patent Document 1] Japanese Patent Application Publication Laid-Open No. H10-169780
[Patent Document 2] Japanese Patent Application Publication Laid-Open No. 2000-63744
[Patent Document 3] Japanese Patent Application Publication Laid-Open No. H2-64109

### SUMMARY OF THE INVENTION

### Problem to be solved by the Invention

Therefore, an attaching operation to fit a conventional waterproof gasket to a line groove of a case is remarkably hard.

Further, a technique to embed a metal wire or a hard resin material in a waterproof gasket can be hardly applied to a waterproof gasket having a remarkably fine wire shape.

More particularly, when a the waterproof gasket according to the technique to embed a metal wire or a hard resin material in a waterproof gasket or a technique to enclose a high hardness rubber with a low harness rubber is used between two members of a case made of a resin material of a cellular phone, the case made of a resin material may be deformed, because a sufficient interference is necessary in order to realize sufficient airtightness.

The present invention solves the above-described problems, and an objective of the present invention is to provide a waterproof gasket capable of being easily handled and keeping sufficient sealing ability between two members where waterproof gasket contacts.

Further, an objective of the present invention is to provide a waterproof gasket having insertion resistance of the waterproof gasket which is suppressed to be low while sufficient sealing ability being kept.

Furthermore, an objective of the present invention is to provide a waterproof gasket having insertion resistance of the waterproof gasket which is reduced without sealing ability of a waterproof gasket being reduced.

### Means for solving the problem

A waterproof gasket of the present invention is a waterproof gasket which is provided between members constituting a case of an electronic apparatus and includes a gasket main body made of a rubber elastic material and a surface layer formed by treating the surface of the gasket main body with a reactive surface treating agent.

According to the waterproof gasket of the present invention, when the reactive surface treating agent is a silylisocyanate compound, a non-adhesive waterproof gasket having low insertion resistance can be provided.

According to the waterproof gasket of the present invention, the reactive surface treating agent is composed of (1) a reaction product from polysiloxane including a terminal hydroxy group and silylisocyanate, (2) a reaction product from silylisocyanate and oligomer having functional group reactive with an isocyanate group, (3) silylisocyanate oligomer represented by the following general formula: 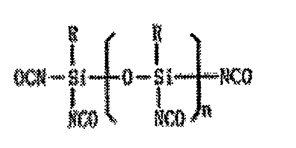 (where R is an alkyl, aryl, or isocyanate group; and n is an integer of one or more), and (4) an organic solvent-soluble rubber. Thus, a surface layer as a treated layer can be made strong without exfoliation.

According to the waterproof gasket of the present invention, even when the case of an electronic apparatus is made of a resin material, the case is not deformed, and thus sufficient sealing ability can be exerted.

According to the waterproof gasket of the present invention, since the silicone rubber mentioned above is a liquid silicone rubber, the remarkably thin waterproof gasket having a fine wire shape of 0.4 mm to 1.6 mm can be easily produced.

### Effects of the Invention

The present invention has the following effects.

According to a waterproof gasket of the present invention described in claim 1, insertion resistance is low, and an attaching operation to fit the gasket to a line groove of a case is easy.

Further, according to a waterproof gasket of the present invention described in claim 2, since a surface layer is chemically bonded (covalently bonded) with a gasket main body, the surface layer does not exfoliate and the surface layer of several µm can be formed.

Further, according to a waterproof gasket of the present invention described in claim 3, many chemical bonds are formed between a functional group of a rubber of a gasket main body and a surface treating agent, and thus durability and non-adhesiveness of the surface can be sufficiently exercised.

Further, according to a waterproof gasket of the present invention described in claim 4, even when the case of an electronic apparatus is made of a resin material, the case is not deformed, and thus proper sealing ability can be exercised.

Further, according to a waterproof gasket of the present invention described in claim 5, since a gasket main body is made of a silicone rubber, excellent adhesion and follow-up ability with respect to a case are obtained.

Further, according to a waterproof gasket of the present invention described in claim 6, a remarkably thin waterproof gasket having a fine wire shape of 0.4 mm to 1.6 mm can be easily produced.

Furthermore, according to a waterproof gasket of the present invention described in claim 7, when the gasket is provided between members constituting a case of an electronic apparatus, this constitution is particularly effective.

### BRIEF EXPLANATION OF DRAWINGS

Fig. 1 is a perspective view to illustrate an embodiment of a waterproof gasket according to the present invention.

Fig. 2 is a half cross sectional view taken along the line of A-A in Fig. 1.

### EXPLANATION OF REFERENCE NUMERALS

1 gasket
2 gasket main body
3 surface layer

### DETAILED DESCRIPTION OF PREFERRED EMBODIMENT

Preferred embodiments to carry out the present invention will be described below.

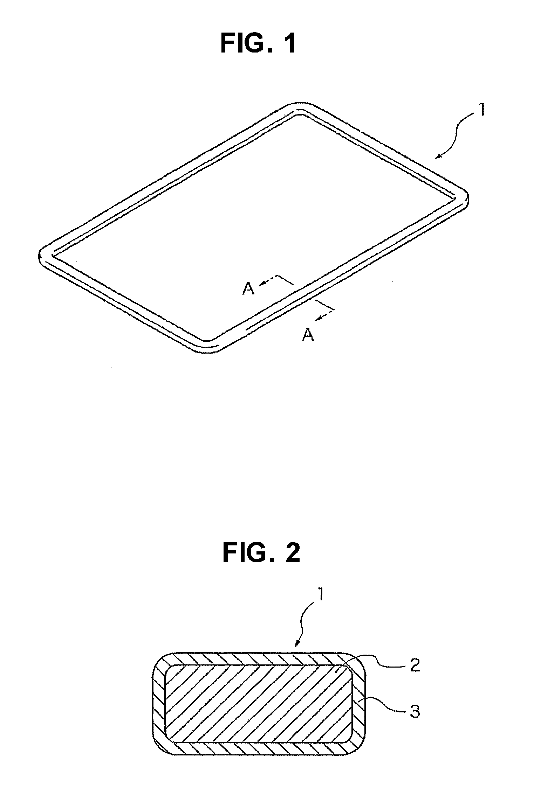

Preferred embodiments to carry out the present invention will be described with reference to Figs. 1 and 2.

A waterproof gasket 1 provided between members constituting a case of an electronic apparatus includes a gasket main body 2 made of a rubber like elastic material, and a surface layer 3 formed by treating a surface of the gasket main body 2 with a reactive surface treating agent.

A material of the gasket main body 2 is properly selected to be used from a synthetic rubber, e.g., a silicone rubber, a fluororubber, NBR, hydrogenated NBR, EPDM, SBR, or an acrylic rubber, a natural rubber, and a thermoplastic elastomer.

However, since a waterproof gasket provided between members constituting a case of an electronic apparatus is required to be thin and have low hardness, a silicone rubber is particularly preferable.

Further, among silicone rubbers, a liquid silicone rubber is the most preferable for a waterproof gasket provided between members constituting a case of an electronic apparatus which is required to have highly accurate workability.

As for the reactive surface treating agent, a silylisocyanate compound having a Si-NCO group can be used.

The compound can be triethylsilylisocyanate [(C2H5)3SiNCO] where one NCO group bonds to a silicon atom, butoxysilanetriisocyanate [C4H9OSi(NCO)3] where three NCO groups bond to a silicon atom, or the like. The compound can be used independently or by mixing those.

Particularly, a reactive surface treating agent having the following combination can be preferably used.

The reactive surface treating agent is composed of (1) a reaction product from polysiloxane including a terminal hydroxy group and silyl isocyanate, (2) a reaction product from silylisocyanate and oligomer having functional group reactive with an isocyanate group, (3) silylisocyanate oligomer represented by the following general formula: 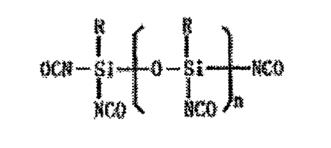 (where R is an alkyl, aryl, or isocyanate group; and n is an integer of one or more), and (4) an organic solvent-soluble rubber.

The polysiloxane including a terminal hydroxy group to form the reaction product of the component (1) can be polysiloxane having at least one terminal hydroxy group in a molecule, e.g., α,ω-dihydroxypolydimethylsiloxane or α,ω-dihydroxypolydiphenylsiloxane. These polysiloxanes have viscosity (at a room temperature) of about 100 to 100,000 cst, and preferably about 100 to 10,000 cst.

Further, the oligomer to form the reaction product of the component (2) can be oligomer having a functional group reactive with an isocyanate group, e.g., a hydroxyl group, a carboxyl group, an amino group, or a thiol group. The oligomer has a molecular weight of about 10,000 or less, and preferably about 1000 to 7000. For example, a polyester resin, a butyral resin, an acrylic resin, a fluororesin, and nitrocellulose, which are in an oligmer state and have the functional group, are used. Preferably, a hydroxyl group-containing polyester resin, a hydroxyl group-containing fluororesin, a butyral resin, and nitrocellulose are used.

The polysiloxane including the functional group and the oligmer are used by previously reacting it with silylisocyanate in an amount of more than one equivalent, generally 1 to 100 times equivalent, and preferably 1 to 50 times equivalent. For example, the silylisocyanate can be methyltriisocyanate silane, ethyltriisocyanate silane, isopropyltriisocyanate silane, butyltriisocyanate silane, phenyltriisocyanate silane, dimethyldiisocyanate silane, diethyldiisocyanate silane, or tetraisocyanate sialne.

Polysiloxane having a reactive function group or oligomer is reacted with silylisocyanate by dropping silylisocyanate into an organic solvent solution of polysiloxane or oligomer. Polysiloxane and oligomer are separately reacted in general but can be simultaneously reacted. The reaction is carried out at a room temperature to about 150°C, and preferably a room temperature to about 100°C.

The organic solvent used as a reaction solvent can be an arbitrary solvent if it can dissolve polysiloxane or oligomer and does not react with an isocyanate group. For example, the organic solvent can be esters such as ethyl acetate, butyl acetate, propylene glycol monomethyl acetate, or ethyl cellosolve acetate, ethers such as dibutyl ether, ethylene glycol dimethyl ether, ethylene glycol dibutyl ether, or tetrahydrofuran, aromatic hydrocarbons such as toluene or xylene, ketones such as acetone, methyl ethyl ketone, methyl isobutyl ketone, or cyclohexanone, or a protonic polar solvent such as dimethylformamide, dimethylacetamide, dimethylsulfoxide, or N-methyl-2-pyrolidone. These solvents can be used independently or by mixing.

The silylisocyanate oligomer of the component (3) can be a compound represented by the above-described general formula. In this formula, R is an alkyl group such as a methyl group, an ethyl group, or a butyl group, an aryl group represented by a phenyl group, or an isocyanate group, and n is preferably 1 to 4.

Further, the organic solvent-soluble rubber of the component (4) is a synthetic rubber being soluble in various kinds of an organic solvent, e.g., NBR, SBR, a isoprene rubber, a butadiene rubber, a chloroprene rubber, a butyl rubber, EPDM, an urethane rubber, a fluororubber, an acrylic rubber, an epichlorohydrin rubber, chlorinated polyethylene, or chlorosulfonated polyethylene, or a natural rubber. Preferably, the component (4) is NBR, and more preferably NBR containing carboxyl group or hydroxyl group, or a carboxyl group or amino group-modified butadiene- acrylonitrile copolymer.

The ratio of each component is that the component (1) is about 1 to 50% by weight and preferably about 1 to 10% by weight, the component (2) is about 1 to 50% by weight and preferably about 1 to 10% by weight, the component (3) is about 3 to 50% by weight and preferably about 3 to 20% by weight, and the component (4) is about 0.01 to 10% by weight and preferably about 0.05 to 5% by weight. A residual part is an organic solvent.

As for the mixing ratio of each component, when the ratio is less than the above-described range, non-stickiness decreases in the component (1), and adhesiveness decreases in the components (2), (3), and (4). On the other hand, when the mixing ratio is more than the above-described range, falling off of the component occurs in the component (1), non-stickiness decreases in the components (2) and (4), and a pot life is shortened in the component (3).

The surface treating agent which includes the above-described components as essential components is once prepared as an organic solvent solution having a solid part concentration of about 5 to 20% by weight, and is further diluted with an organic solvent according to a coating thickness or a coating method.

The coating thickness is generally about 1 to 20µm, and preferably 2 to 10µm. When the thickness is less than 1µm, the treated surface cannot be wholly covered so that non-stickiness decreases, and further, sealing ability decreases when it is applied to a sealing material. On the other hand, when the coating thickness is more than 20µm, rigidity of the surface of a sealing material increases so that sealing ability or flexibility may decrease. The coating method is also arbitrary. The method is generally a dipping method, a spray method, a roll coater method, a flow coater method, or the like. After coating, a heating treatment is carried out at about 80 to 250°C, preferably about 120 to 200°C, for 3 minutes to 1 hour.

The reactive surface treating agent chemically reacts with various kinds of functional groups on the surface of the gasket main body so as to form a silicone structure.

Therefore, the gasket main body 1 and the surface layer 3 are strongly bonded.

Further, as for a case of an electronic apparatus, a thin case made of a resin material or an aluminum material is used in order to reduce the weight.

However, when a waterproof gasket is inserted and held in the thin case made of a resin material so as to obtain sealed face pressure of the waterproof gasket, there has been a risk that the case may be deformed.

Thus, this problem can be solved by using a silicone rubber having rubber hardness (JIS-A) of 40 to 80°, preferably 50 to 70°.

Further, the remarkably thin gasket main body 2 having a fine wire shape of 0.4 to 1.6mm is used for the waterproof gasket 1 provided between members constituting a case of an electronic apparatus.

Furthermore, needless to say, the present invention is not limited to these preferred embodiments to carry out the invention, but can have the other constitutions if these are not out of the objective of the present invention.

### Industrial applicability

The present invention can be properly used between two members of a case made of a resin material of a cellular phone.

## Claims

1. A waterproof gasket (1) for an electronic apparatus which is provided between members constituting a case of the electronic apparatus and comprises:
a gasket main body (2) made of a rubber like elastic material; and
a surface layer (3) formed by treating a surface of the gasket main body with a reactive surface treating agent.

2. The waterproof gasket as claimed in claim 1,
wherein the reactive surface treating agent is a silylisocyanate compound.

3. The waterproof gasket as claimed in claim 1 or 2,
wherein the reactive surface treating agent comprises:
(1) a reaction product of polysiloxane including a terminal hydroxy group and silylisocyanate;
(2) a reaction product of silylisocyanate and oligomer having a functional group reactive with an isocyanate group;
(3) silylisocyanate oligomer represented by the following general formula: 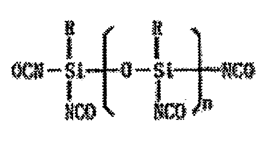 (where R is an alkyl, aryl, or isocyanate group; and n is an integer of one or more); and
(4) an organic solvent-soluble rubber.

4. The waterproof gasket as claimed in any one of claims 1 to 3,
wherein the case of an electronic apparatus is made of a resin material.

5. The waterproof gasket as claimed in any one of claims 1 to 4,
wherein the rubber like elastic material is a silicone rubber.

6. The waterproof gasket as claimed in any one of claims 1 to 5,
wherein the silicone rubber is a liquid-state silicone rubber.

7. The waterproof gasket as claimed in any one of claims 1 to 6,
wherein the gasket main body (2) has a fine wire shape of 0.4mm to 1.6mm.
